# EUROPEAN PATENT APPLICATION

(11) **EP 1 837 393 A2**
(43) Date of publication of application: **26.09.2007**
(21) Application number: 07005841.7
(22) Date of filing: 21.03.2007
(51) Int. Cl.: C11D 1/44, C11D 3/00, C11D 3/20, C11D 11/00, H01L 21/321

(54) **Cleaning solution for substrate for use in semiconductor device and cleaning method using the same**

(30) Priority: 22.03.2006 JP 2006079730
(71) Applicant: FUJIFILM Corporation, Minato-ku Tokyo (JP)
(72) Inventor: Nishiwaki, Yoshinori, Haibara-gun, Shizuoka-ken (JP)
(74) Representative: HOFFMANN EITLE

(57) **Abstract**

The invention provides a cleaning solution for use in cleaning a substrate for semiconductor device use after a chemical mechanical polishing process has been carried out in production of a semiconductor device. The cleaning solution contains a compound represented by the following formula (I) and an organic acid. In formula (1), R represents a hydrocarbon group, and n and m each independently represent an integer of 2 or more.

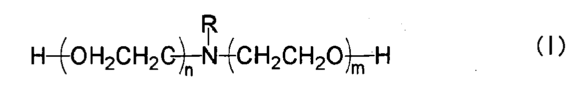

## Description

### BACKGROUND OF THE INVENTION

### Field of the Invention

The present invention relates to a cleaning solution used, after planarization by Chemical Mechanical Polishing (hereinafter, sometimes referred to as "CMP"), in a cleaning process in production of a semiconductor device, a cleaning process of a substrate for semiconductor device use, and a cleaning method using the same.

### Description of the Related Art

In the development of semiconductor devices, typified by semiconductor integrated circuits (hereinafter, referred to as "LSI"), the following processes are generally carried out. Often a shallow trench isolation (STI) film, which is also known as an element separation film, is formed at a lower portion of a substrate, and then multiple layers, such as insulation film(s) and metal film(s) are laminated thereon to compose a multilayered laminated structure. When laminating multiple layers, an interlayer insulation film using an ordinary interlayer insulation film such as a p-TEOS film or an O₃-TEOS film, as well as an interlayer insulation film (interlayer dielectric (ILD) films) including an interlayer film having a low dielectric constant of about 3.5 to 2.0 (for example, an organic polymer based film, a methyl group containing silica based film, a H-Si containing silica based film, a SiOF based film, a porous silica based film, and a porous organic material based film, which are usually referred to as low-k films), and metal films are deposited on the substrate. Then the resulting unevenness due to the deposition process is planarized by carrying out a planarizing treatment by CMP, and new wiring is laminated on the planarized surface.

In recent years, along with progress in reducing the width of lines of semiconductor devices, planarity at high accuracy has becoming more and more necessary in each of the layers of the substrate.

Accordingly, the expectations on CMP are high, and a planarizing process by CMP is becoming popular in production processes for semiconductor devices, and the subsequent cleaning process is also playing an important role.

In the planarizing processes by CMP, for a single substrate specific polishing slurries are used for each film depending on the property of the film(s) to be polished and planarized, and polishing conditions and polishing liquids are generally changed in plural planarizing processes. Depending on the planarizing process, the composition and components of cleaning solution used after CMP are also different.

Abrasives contained in a polishing liquid, which is used for a low-k film or a film mainly composed of silica such as an ILD film and a STI film, include finely particulate powder of fumed silica, colloidal silica, and cerium oxide. The polishing liquid used is one prepared by dispersing the abrasives in water. In the polishing liquid described above, a water-soluble macromolecule, a surfactant, inorganic salt, and a precipitation inhibitor, and the like are used in combination as additives. Further, abrasive-free polishing liquids containing no abrasives at all, and polishing liquids containing extremely small amounts of abrasives, are also used.

A polishing liquid containing combinations of an oxidizing agent such as hydrogen peroxide, iron nitrate, and hydroxy amine, an abrasive such as finely particulate alumina, fumed silica, and colloidal silica, and a chelating agent and, further, containing a corrosion inhibitor, and other additives, is used for metal films such as of Cu, W or Al, or nitride films.

After such a CMP process for planarizing, some of polished away metal (contaminant metal) and abrasives (contaminant particles) are left on a wafer surface. To remove these contaminant particles and contaminant metal down to a target level, a process using a cleaning solution is generally carried out.

As a cleaning solution used in such a cleaning process, various cleaning solutions such as a cleaning solution containing a specific surfactant and alkali or organic acid (see, for example, Japanese Patent Application Laid-Open (JP-A) No. 2003-289060), and a cleaning solution containing organic acid, organic alkali, and surfactant (see, for example, JP-A No. 2005-260213) were proposed. However, these cleaning solutions were not perfect from a viewpoint of efficient removal of metal or substrate material derived from materials to be polished, and residue of organic matter or abrasive granules.

### SUMMARY OF THE INVENTION

The invention has been made in view of the circumstances described above.

A first aspect of the invention is to provide a cleaning solution for use in cleaning a substrate for semiconductor device use after a chemical mechanical polishing process has been carried out in production of a semiconductor device. The cleaning solution contains a compound represented by the following formula (I) and an organic acid.

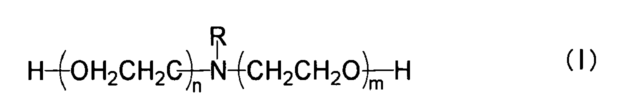

In formula (I), R represents a hydrocarbon group, and n and m each independently represent an integer of 2 or more.

A second aspect of the invention is to provide a cleaning method of a substrate for semiconductor device use, comprising cleaning the substrate with the cleaning solution of the invention.

The cleaning solution of the invention is preferably prepared by dissolving the essential components, that is, the compound represented by formula (I) and the organic acid, in an aqueous solvent.

The substrate for semiconductor device use, to be cleaned by the cleaning solution of the invention, is a substrate that has had a chemical mechanical polishing process carried out on it in the production of a semiconductor device. The substrate is either a single-layer substrate, having metal wiring formed on the substrate material surface, or a multilayered wiring board, having wiring formed on the surface with an interlayer insulation film or the like therebetween.

### DETAILED DESCRIPTION OF THE INVENTION

The present invention will be described in detail below. In the present specification "... to ..." represents a range including the numeral values represented before and after "to" as a minimum value and a maximum value, respectively.

The cleaning solution for use in cleaning a substrate for semiconductor device use after a chemical mechanical polishing process has been carried out in production of a semiconductor device. The cleaning solution contains a compound represented by the following formula (I) and an organic acid. Components of the cleaning solution of the invention are sequentially described below.

### [(A) Compound represented by formula (I)]

The cleaning solution of the invention contains a compound represented by the following formula (I) (hereinafter, sometimes referred to as "specific compound").

The compound represented by the following formula (I) is a compound having a property as nonionic surfactant, and may exhibits a cationic property if the additional molar number n or m of ethylene oxide unit is small.

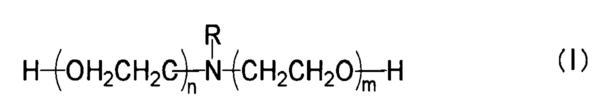

In formula (I), R represents a hydrocarbon group.

R preferably represents a hydrocarbon group having 2 to 30 carbon atoms, and the hydrocarbon group may contain a hetero atom such as oxygen atom or nitrogen atom in its structure.

The hydrocarbon group may also have a substituent, and the substituent possibly introduced to the hydrocarbon atom includes a hydroxyl group, a phenyl group, or a benzyl group.

Specific examples ofR include an alkyl group, and an aryl group, and an alkyl group is particularly preferable.

Preferable examples of R include a methyl group, an ethyl group, a propyl group, an isopropyl group, an n-butyl group, a tert-butyl group, a pentyl group, a hexyl group, an octyl group, a nonyl group, -C₁₂H₂₅, -C₁₈H₃₇, and -C₁₂H₂₄OH.

In formula (I), n and m each independently represent an integer of 2 or more, and the sum of m and n is preferably in the range of from 4 to 1000. Preferably n and m are in the range of from 2 to 100, or more preferably in the range of from 4 to 70.

n and m may be the same or different each other, and are preferably the same from the viewpoint of synthesis suitability.

Examples of the compound represented by formula (I) are shown below, but the invention is not limited to these examples.

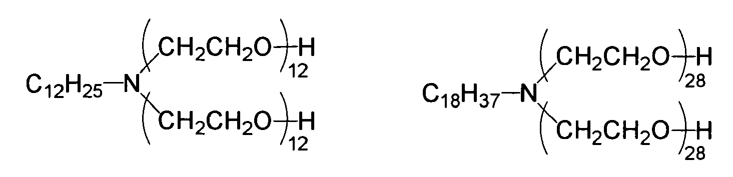

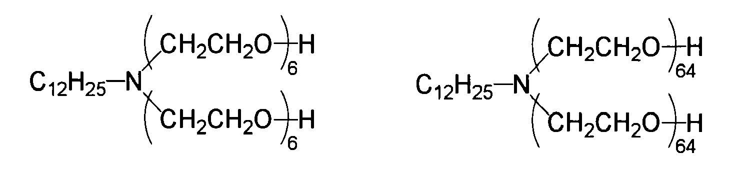

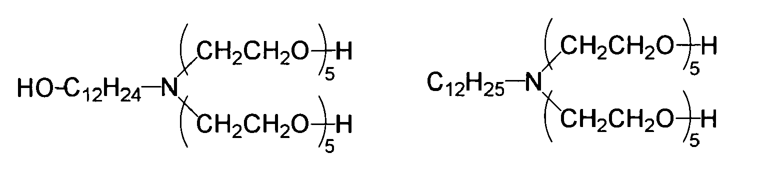

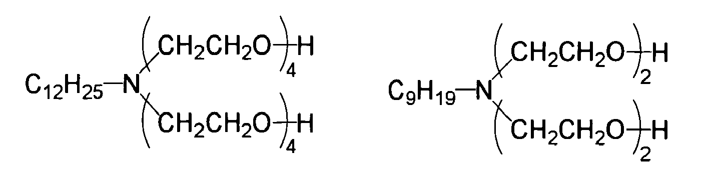

The content of the compound represented by formula (I) as converted to a solid content amount in the cleaning solution is in a range of from 0.0001 to 1 mass%, more preferably 0.003 to 0.1 mass%, and particularly preferably 0.001 to 0.05 mass%.

### [Organic acid]

The cleaning solution of the invention contains an organic acid.

The organic acid of the invention is an organic compound showing acidity (pH < 7) in water, and having acidic functional group such as a carboxy group, a sulfo group,a phenolic hydroxyl group, and a mercapto group.

The organic acid contained in the cleaning solution of the invention is not particularly limited, and is preferably an organic carboxylic acid having a carboxyl group in a molecule, and an organic acid selected from the following group are more preferable.

Preferable examples of the organic carboxylic acid of the invention include formic acid, acetic acid, propionic acid, oxalic acid, butyric acid, valeric acid, 2-methyl butyric acid, n-hexanic acid, 3,3-dimethyl butyric acid, 2-ethyl butyric acid, 4-methyl pentanic acid, n-heptanic acid, 2-methyl hexanic acid, n-octanic acid, 2-ethyl hexanic acid, benzoic acid, glycolic acid, salicylic acid, glyceric acid, malonic acid, succinic acid, glutaric acid, adipinic acid, pimellic acid, maleic acid, phthalic acid, malic acid, tartaric acid, citric acid, and lactic acid.

Among them, acetic acid, propionic acid, oxalic acid, succinic acid, malonic acid, citric acid, tartaric acid, and malic acid are preferable as the organic acid of the invention.

The content of organic acid in the cleaning solution of the invention is preferably in a range of form 0.01 to 30 mass% with respect to the total mass amount of the cleaning solution, more preferably 0.05 to 10 mass%, and particularly preferably 0.1 to 2 mass%.

The cleaning solution of the invention is an aqueous solution. That is, essential components are dissolved in the aqueous solvent. Water used as solvent is preferably free of impurities from a viewpoint of its effect, or deionized water or superpurified water extremely lowered in the content of impurities is preferable. From a similar point of view, electrolytic ion water obtained by electrolysis of water, or hydrogen water having hydrogen gas dissolved in water may be also used.

The pH value of the cleaning solution of the invention is preferably 1 or more from a viewpoint of suppressing corrosion of substrate surface, more preferably 1.5 or more and more preferably 2 or more, and particularly preferably 3 or more. On the other hand, from a viewpoint of sufficient removal of metal contamination, the pH is preferably 6.5 or less, more preferably 6 or less, and particularly preferably 5 or less.

### [Other components]

The cleaning solution of the invention may contain other compounds as required within a range not spoiling the effect, in addition to the essential components of the compound represented by formula (I), the organic acid, and water as solvent. Usable components are described below.

### (Surfactant)

The invention preferably contain a surfactant different from the compound represented by formula (I).

The surfactant usable in the invention is not particularly limited, and includes anionic surfactant, nonionic surfactant, cationic surfactant, and amphoteric surfactant.

The anionic surfactant includes an alkyl sulfonic acid and its salt, an alkyl benzene sulfonic acid and its salt, an alkyl diphenyl ether disulfonic acid and its salt, an alkyl methyl tauric acid and its salt, an alkyl sulfuric ester and its salt, an alkyl ether sulfuric ester and its salt, and a sulfosuccinic diester and its salt.

The nonionic surfactant includes a polyoxy ethylene alkyl ether, a polyoxy ethylene fatty acid ester, and other alkylene oxide surfactants.

The cationic surfactant includes an amine salt type surfactant, and a quaternary ammonium salt type surfactant.

The amphoteric surfactant includes an amino acid type amphoteric surfactant, and a betaine type amphoteric surfactant.

As the surfactant, the anionic surfactant is preferable. Further preferable examples include an alkyl benzene sulfonic acid having 8 to 12 carbon atoms and its salt, an alkyl diphenyl ether disulfonic acid having 8 to 12 carbon atoms and its salt, an alkyl methyl tauric acid having 8 to 12 carbon atoms and its salt, an alkyl sulfuric ester having 8 to 12 carbon atoms and its salt, an alkyl ether sulfuric ester having 8 to 12 carbon atoms and its salt, a sulfosuccinic diester having 8 to 12 carbon atoms and its salt, and the like. These surfactants may be used alone or in combination of two or more.

The content of surfactant in the cleaning solution of the invention is generally 0.0001 to 1 mass% with respect to the total mass of the cleaning solution, preferably 0.0003 to 0.1 mass%, and more preferably 0.001 to 0.05 mass%.

### (Chelating agent)

The cleaning solution of the invention may contain a chelating agent, if necessary, for reducing adverse effect caused by mixing of polyvalent metal ions. As the chelating agent, a generally demineralizing agent for hard water hard water may be used for a precipitation preventing agent of calcium and magnesium or a related compound thereof. The agent may be used alone, or in combination of plural kinds of the components as needed.

The addition amount of the chelating agent is not restricted, as long as the amount is sufficient for blocking metal ions such as contaminated polyvalent metal ions, and is generally about 5 ppm to 10000 ppm in the cleaning solution.

### [Cleaning method of a substrate for use in a semiconductor device]

The cleaning method of a substrate for semiconductor device use of the invention is carried out immediately subsequent to a chemical mechanical polishing process in the production of a semiconductor device, and the cleaning solution of the invention is used.

The cleaning solution of the invention is preferably used for cleaning a substrate for semiconductor device use having formed on the surface thereof a metal layer or metal compound layer, or wiring composed of them.

Usually, a CMP process is a polishing process of supplying a polishing liquid to a polishing pad placed on a polishing platen; bringing the polishing pad into contact with a surface to be polished of an object to be polished such as a substrate for semiconductor device use, and relatively moving the surface to be polished and the polishing pad. In the subsequent cleaning process, generally, the polished substrate for semiconductor device use is put on a spinner, and the cleaning solution is supplied onto the surface to be polished and onto the back side of the substrate at flow rate of 100 to 2000 ml/min, and the substrate is brush scrubbed for 10 to 60 seconds at room temperature.

A commercial cleaning machine, for example, a wafer cleaning machine (trade name: ZAB8W2M, manufactured by MAT) may be used, and scrub cleaning may be carried out with contact of a PVA roll brush used in the scrub section of the cleaning machine.

Examples of the metal used in the substrate for semiconductor device use to be polished are metals mainly of W or Cu. Recently, it has become possible to develop LSIs using copper of low wiring resistance. With the recent trend to finer widths of wiring for increasing the density, it is required to enhance the conductivity of copper wiring and resistance to electron migration, and, for such materials of high precision, technology for high productivity processing that does not cause contamination is required. In the processes for cleaning a substrate having Cu formed on the surface, or a substrate having an insulation film of low dielectric constant as an interlayer insulation film and having a copper wiring formed on the surface thereof, in particular in cleaning processes that are conducted after chemical-mechanical polishing (CMP) processing of a Cu film, or cleaning processes that are conducted after opening holes in the interlayer insulation film on the wiring by dry etching, in these cleaning processes it is particularly important to have efficient removal of impurity metals and particles left over on the surface for the sake of purity and precision of wiring, and the cleaning solution of the invention is preferably used in these cleaning processes from such point of view.

To confirm the effectiveness of impurity removal in the cleaning process, foreign matter on a wafer must be detected. In the invention, a light scatter type foreign matter measuring instrument (for example, Trade Name: SP1TBI; manufactured by KLA Tencor) is preferably used as a foreign matter detecting device. In this system, to detect foreign matter on the wafer, a laser beam is emitted to the wafer surface, and, instead of detecting the normal reflected light of the laser beam, the light intensity of the scattered laser beam is measured by a photo detector disposed in a predetermined direction is measured, thereby detecting that there is foreign matter on the wafer. The laser beam sequentially scans the wafer surface, but if an uneven portion such as foreign matter exists on the wafer surface, a change in the scattering intensity occurs. In this system, the light scattering intensity is compared with light scattering intensities preliminarily calibrated using standard particles, and the light scattering intensity is converted into a standard particle, and the size and position of foreign matter can be displayed.

In addition, by water mark evaluation described in the following examples, the state of an object surface after cleaning can be determined.

According to the cleaning method using the cleaning solution of the invention, impurity metals and particles, left on the surface of substrate for semiconductor device use after planarizing process by CMP, can be removed efficiently. The cleaning method using the cleaning solution of the invention is particularly suitable for devices which require efficient removal of impurities at each process, in particular when planarizing for a device demanding high precision of wiring, or for a multilayered wiring board forming an interlayer insulation film and then new wiring after planarizing of single-layer substrate.

### EXAMPLES

Examples of the invention are described below. However, the invention is not limited to these examples.

### <Preparation of polishing liquid>

- Abrasives: colloidal silica (average particle size 30 nm) 5 g/L
- Benzotriazole (BTA) 1 g/L
- Glycine 10 g/L

Purified water was added to prepare a total volume of 1000 mL, and the pH was adjusted to 4.5 by using nitric acid and ammonia.

Just before polishing 15 g/L of 30% hydrogen peroxide (oxidizing agent) was added to the polishing liquid, and the polishing was carried out.

### <Polishing of Cu wafer>

The polishing device was an LGP-613 manufactured by Lap Master, while supplying the obtained polishing liquid, the films on each wafers were polished under the following conditions.
Substrate: silicon wafer with 8-inch copper film
Table rotation speed: 50 rpm
Head rotation speed: 50 rpm
Polishing pressure: 168 hPa
Polishing pad: trade name IC-1400 manufactured by Rodel Nitta
Slurry supply speed: 200 ml/min

### Examples 1 to 5, Comparative Examples 1 to 7

### <Preparation of cleaning solution>

- Organic acid or organic alkali (compound shown in Table 1), (amount shown in Table 1)
- Compound represented by formula (I) (specific compound), or surfactant as control (compound shown in Table 1), (amount shown in Table 1)

The total volume was adjusted to 1000 mL by adding pure water.

In Table 1, POE alkylamine denotes polyoxyethylene alkylamine contained in the compound represented by formula (I), and its structure is indicated by showing both the alkyl group (R) in formula (I) and the number (m, n) of ethylene oxide structural units added. TMAH represents tetramethyl ammonium hydroxide, and TEAH represents tetraethyl ammonium hydroxide.

### <Cleaning test>

The cleaning test was carried out by the silicon substrates with a copper film that had been polished under the above specified condition being cleaned by the specified polishing liquid of Examples 1 to 6 and Comparative Examples 1 to 7.

The substrate was cleaned by using contact scrub cleaning with a PVA roll brush in the scrub section of the wafer cleaning machine (trade name: ZAB8W2M, manufactured by MAT).

Each cleaning solution was mixed and diluted with purified water of 20 times by volume before use, and was continuously supplied for 25 seconds at flow rate of 650 ml/min at the upper side of the substrate and 500 ml/min at the lower side, and then purified water (deionized water) was supplied continuously for 35 seconds at flow rate of 650 ml/min at the upper side of the substrate and 500 ml/min at the lower side, and the substrate was finally dried for 30 seconds by the spin drying device in the cleaning machine.

### <Abrasive residue evaluation>

Particles of 0.2 µm or larger remaining on the Cu wafer surface thus cleaned and dried were counted, and the abrasive residue was evaluated. Particles were measured by a SP1-TB1 manufactured by KLA-TENCOR.

The evaluation was ranked as A when the measured number of defects was in the range of 500 or less, B in the range of 501 to 5000, and C in the range of 5001 or more.

### <Water mark evaluation>

In the same way as in <Abrasive residue evaluation>, TEOS wafers (1500 nm of oxide layer (SiO₂) formed on silicon wafers) were cleaned and dried, and the state of wafer surface was visually observed, and water mark was evaluated.

High pressure water ejected from a nozzle end in a cleaning process generates a huge quantity of mist on the semiconductor substrate surface, and the majority is discharged from the exhaust port, but part is left floating in the chamber, which readheres to the semiconductor substrate surface. The mist may contain adsorbed dust from the vapor phase, and when the moisture in the mist evaporates after sticking, dust particles may be left over and stick to the semiconductor substrate surface, and visible marks are left over on the surface, which are hard to remove. If mist not containing dust adheres to the semiconductor substrate surface, when moisture is evaporates traces of the mist may be left over, which are known as water marks. If the surface is clean, then no water marks are observed, and so by the presence or absence of water marks, the presence or absence of impurities can be estimated. It is thus evaluated favorably when no water marks are found.

The results are shown in Table 1.

**Table 1**

| | (B) Organic acid or organic alkali | | (A) Specific compound or surfactant as control | | | | | Abrasive residue (on Cu) | Water mark (on TEOS) |
|---|---|---|---|---|---|---|---|---|---|
| | Compound | g/L | Compound | R | m | n | g/L | | |
| Example 1 | Citric acid | 8.3 | POE alkylamine (formula (I)) | C₁₂H₂₅ | 12 | 12 | 0.2 | A | None |
| Example 2 | Citric acid | 8.7 | POE alkylamine (formula (I)) | C₁₈H₂₅ | 28 | 28 | 0.22 | A | None |
| Example 3 | Oxalic acid | 15.0 | POE alkylamine (formula (I)) | C₁₂H₂₅ | 6 | 6 | 0.2 | A | None |
| Example 4 | Lactic acid | 16.0 | POE alkylamine (formula (I)) | C₁₂H₂₅ | 64 | 64 | 0.2 | A | None |
| Example 5 | Oxalic acid | 8.0 | POE alkylamine (formula (I)) | C₁₂H₂₄0H | 6 | 6 | 0.22 | A | None |
| Comparative Example 1 | TMAH | 5.0 | POE alkylamine (formula (I)) | C₁₂H₂₅ | 12 | 12 | 0.18 | B | None |
| Comparative Example 2 | TMAH | 10.0 | POE alkylamine (formula (I)) | (C₂H₄O)₃H | 6 | 6 | 0.2 | B | None |
| Comparative Example 3 | TEAH | 6.0 | Polyoxy ethylene lauryl ether | - | - | - | 0.2 | B | None |
| Comparative Example 4 | Citric acid | 9.0 | Dodecyl benzene sulfonic acid | - | - | - | 0.25 | B | Found |
| Comparative Example 5 | Oxalic acid | 12.0 | Not used | | | | 0 | C | Found |
| Comparative Example 6 | Citric acid | 8.0 | Not used | | | | 0 | C | Found |
| Comparative Example 7 | HCl | 6.0 | POE alkylamine (formula (I)) | C₁₂H₂₅ | 6 | 6 | 0.22 | B | None |

As shown in Table 1, by using the cleaning solution of the invention, foreign matter on the Cu wafer after polishing can be removed efficiently, and the surface is cleaned to such a level that formation of water mark can be suppressed.

As described above, the invention provides a cleaning solution being used for cleaning a substrate for use in a semiconductor device after carrying out a chemical mechanical polishing process in production of semiconductor device, that can efficiently removes impurity metals, impurity inorganic materials, impurity organic materials, particles such as abrasives, and the like which are left on a metal film, an element separation film, an interlayer insulation film, a nitride film, and a metal wiring, and the like formed on a base material such as a silicon wafer. Further, the invention provides a cleaning method using the cleaning solution of the invention.

The foregoing description of the embodiments of the present invention has been provided for the purposes of illustration and description. It is not intended to be exhaustive or to limit the invention to the precise forms disclosed. Obviously, many modifications and variations will be apparent to practitioners skilled in the art. The embodiments were chosen and described in order to best explain the principles of the invention and its practical applications, thereby enabling others skilled in the art to understand the invention for various embodiments and with the various modifications as are suited to the particular use contemplated. It is intended that the scope of the invention be defined by the following claims and their equivalents.

All publications, patent applications, and technical standards mentioned in this specification are herein incorporated by reference to the same extent as if each individual publication, patent application, or technical standard was specifically and individually indicated to be incorporated by reference.

## Claims

1. A cleaning solution for cleaning a substrate for semiconductor device use after a chemical mechanical polishing process has been carried out in production of a semiconductor device, which cleaning solution comprises
i) a compound of the formula (I) : 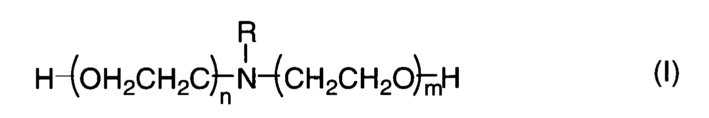 wherein
R is a hydrocarbon group, which is optionally substituted and may contain a hetero atom in its structure, and
n and m each independently represent an integer of 2 or more; and
ii) an organic acid.

2. The cleaning solution of claim 1, wherein R is a hydrocarbon group having 2-30 carbon atoms.

3. The cleaning solution of claim 1 or 2, wherein the sum of m and n is 4-1000.

4. The cleaning solution of any of claims 1-3, which has a pH of 1-5.

5. The cleaning solution of any of claims 1-4, wherein the organic acid is a carboxylic acid.

6. The cleaning solution of claim 5, wherein the carboxylic acid is at least one compound selected from acetic acid, propionic acid, oxalic acid, succinic acid, malonic acid, citric acid, tartaric acid, and malic acid.

7. The cleaning solution of any of claims 1-6, which contains 0.0001-1 wt.-% of the compound of formula (I), based on the total solid content of the cleaning solution.

8. The cleaning solution of any of claims 1-7, which contains 0.01-30 wt.-% of the organic acid, based on the total weight of the cleaning solution.

9. The use of the cleaning solution of any of claims 1-8 for cleaning a substrate for semiconductor device use.

10. The use of claim 9, wherein the substrate has been subjected to a chemical mechanical polishing process prior to cleaning it with the cleaning solution of any of claims 1-8.
